# EUROPÄISCHE PATENTSCHRIFT

(11) **EP 2 389 340 B1**
(45) Veröffentlichungstag und Bekanntmachung des Hinweises auf die Patenterteilung: **19.12.2012**
(21) Anmeldenummer: 09783907.0
(22) Anmeldetag: 09.10.2009
(51) Int. Cl.: C01B 33/035, B01J 19/24, B01J 15/00

(54) **REAKTOR ZUR HERSTELLUNG VON POLYKRISTALLINEM SILIZIUM NACH DEM MONOSILAN-PROZESS**
REACTOR FOR PRODUCING POLYCRYSTALLINE SILICON USING THE MONOSILANE PROCESS
RÉACTEUR POUR PRODUIRE DU SILICIUM POLYCRISTALLIN SELON LA TECHNOLOGIE MONOSILANE

(30) Priorität: 22.01.2009 DE 102009003368
(43) Veröffentlichungstag der Anmeldung: 30.11.2011
(73) Patentinhaber: Schmid Silicon Technology Gmbh, 72250 Freudenstadt (DE)
(72) Erfinder: STÖCKLINGER, Robert, 83620 Feldkirchen-Westerham (DE)
(74) Vertreter: Patentanwälte Ruff, Wilhelm, Beier, Dauster & Partner
(86) Internationale Anmeldenummer: PCT/EP2009/063198
(87) Internationale Veröffentlichungsnummer: WO 2010/083899

(56) Entgegenhaltungen:
- JP-A- 6 285 364
- US-A- 4 179 530
- US-A- 5 041 308
- US-A- 5 382 419

## Beschreibung

Die vorliegende Erfindung betrifft einen Reaktor zur Herstellung von polykristallinem Silizium nach dem Monosilan-Prozess. Im Besonderen umfasst der Reaktor einen Reaktorboden, der eine Vielzahl von Düsen ausgebildet hat. Durch diese Düsen strömt ein siliziumhaltiges Gas ein. Das siliziumhaltige Gas ist Monosilan mit der chemischen Formel SiH₄. Ferner sind auf dem Reaktorboden mehrere Filamentstäbe montiert. Von den Düsen ist eine Gasaustrittsöffnung ausgebildet, über die verbrauchtes siliziumhaltiges Gas einer Anreicherung und/oder Aufbereitung zugeführt wird.

In dem U.S.-Patent 4,179,530 ist ein Verfahren zur Anlagerung von reinem Silizium offenbart. Der Reaktor hierzu besteht aus einem doppelwandigen Behälter. In dem durch die zwei Wände gebildeten Zwischenraum wird Kühlwasser geführt. Der Reaktor umfasst mehrere dünne, U-förmige Filamente, an denen sich das Silizium niederschlägt. Ebenso werden die Klammern der Elektroden gekühlt. Das Gas wird durch Öffnungen im Boden des Reaktors zu - und abgeführt.

Die deutsche Patentanmeldung DE 25 58 387 offenbart ein Verfahren und eine Vorrichtung zur Herstellung von polykristallinem Silizium. Das polykristalline Silizium wird durch Wasserstoffreduktion von Silizium enthaltenden Verbindungen hergestellt. Über eine Beschickungsdüse werden die Reaktionspartner in den Reaktionsraum eingebracht. Die verbrauchten Reaktionspartner werden durch den Auslass durch eine Leitung abgeführt. Einlass and Auslass sind gegenüberliegend angeordnet.

Die deutsche Patentanmeldung DE 10 2005 042 753 A1 offenbart ein Verfahren zur Herstellung von granulatförmigem polykristallinem Silizium in einem Wirbelstromreaktor. Bei dem Verfahren zur Herstellung von granulatförmigem polykristallinem Silizium wird in einem Wirbelschichtreaktor, der eine heiße Oberfläche besitzt, das polykristalline Silizium aus einem Reaktionsgas abgeschieden. Dies läuft bei einer Reaktionstemperatur von 600 bis 1100 °C ab. Die mit dem abgelagerten Silizium versehenen Partikel werden zusammen mit nicht reagiertem Reaktionsgas and Fluidisierungsgas aus dem Reaktor entfernt.

Das U.S.-Patent RE 36,936 offenbart ein Verfahren zur Herstellung von hochreinem polykristallinem Silizium. Hierbei wird ebenfalls das Silizium aus der Abscheidung von Silizium enthaltendem Gas gewonnen. Das in der Kammer zirkulierende Gas schlägt sich auf hierfür vorgesehene and gekühlte Oberflachen nieder. Die Zirkulation des Gases kann mit einem Ventilator erhöht werden.

Die US 4,179,530 A betrifft einen doppelwandigen Reaktor zur Gewinnung von Silizium durch Zersetzung eines siliziumhaltigen Gases. Der doppelwandige Mantel des Reaktors wird mit Kühlwasser gekühlt. Auf dem Reaktorboden sitzen U-förmige Filamentstäbe, des weiteren weist der Reaktorboden Düsen auf, durch die ein siliziumhaltiges Gas einströmt.

Die JP 06 285364 A betrifft einen Reaktor zur katalytischen Umsetzung von Flüssigkeit-Gas- oder Feststoff-Flüssigkeit-Gas-Gemischen, der ein Innenrohr aufweist, wobei das Innenrohr durch den Reaktorboden geführt ist. Das Innenrohr ist geeignet für den Ein- und Auslass von Reaktionsgasen, ist allerdings einwandig ausgebildet. Zur Gewinnung von polykristallinem Silizium ist der Reaktor nicht vorgesehen. Entsprechend weist er auch keine Halterungen für Filamentstäbe im Reaktorboden auf.

Der Erfindung liegt die Aufgabe zugrunde, einen Reaktor für die Herstellung von polykristallinem Silizium derart auszugestalten, dass die Abführung von verbrauchtem siliziumhaltigem Gas (Monosilan: SiH₄) derart ausgestaltet ist, dass der Wirkungsgrad des Reaktors nicht reduziert ist and dass eine sichere Produktion des polykristallinen Siliziums gewährleistet ist.

Die obige Aufgabe wird durch einen Reaktor gelöst, der die Merkmale des Patentanspruchs 1 umfasst.

Bei dem erfindungsgemäßen Reaktor ist die Gasaustrittsöffnung an einem freien Ende eines Innenrohrs ausgebildet. Das Innenrohr ist dabei durch den Reaktorboden geführt. Somit wird das verbrauchte siliziumhaltige Gas (Monosilan) zu einer Anreicherung und/oder Aufbereitung durch den Reaktorboden herausgeführt. Da das freie Ende des Innenrohrs deutlich von den Gaseintrittsdüsen von unverbrauchtem Monosilan beabstandet ist, wird ein Kurzschluss vermieden, so dass es äußerst unwahrscheinlich ist, dass frisch eintretendes Monosilan sofort wieder durch die Austrittsöffnung abgeführt wird, um einer Anreicherung und/oder Aufbereitung unterzogen zu werden. Das Innenrohr besitzt eine äußere Wand und eine innere Wand. Dadurch ist ein Zwischenraum gebildet, in dem mindestens ein Kühlwasserkreislauf geführt ist. Bei einer vorteilhaften Ausgestaltung der Erfindung sind im Zwischenraum des Innenrohrs ein erster und ein zweiter Kühlwasserkreislauf ausgebildet.

Das Innenrohr ist im Zentrum des Reaktorbodens positioniert. Im Reaktorboden ist ebenfalls eine Vielzahl von Gasaustrittsöffnungen ausgebildet. Ebenso ist auf dem Reaktorboden eine Vielzahl von Halterungen für die Filamentstäbe vorgesehen, so dass die Gasaustrittsöffnungen und die Filamentstäbe das Innenrohr umgeben.

Die Wasserkühlung des Innenrohrs gewährleist eine annähernd gleiche Prozesstemperatur an den Filamentstäben. Um die Wasserkühlung des Innenrohrs zu realisieren, ist das Innenrohr doppelwandig ausgebildet.

Der Reaktor und der Reaktorboden sind ebenfalls als Doppelmantel ausgebildet. In den durch den Doppelmantel gebildeten Zwischenraum wird Wasser zur Kühlung geführt.

Der Reaktorboden weist eine spezielle Ausgestaltung auf. Der Reaktorboden umfasst einen ersten Bereich und einen zweiten Bereich. Der erste Bereich ist durch eine dem Innenraum des Reaktors zugewandte Platte und einer Zwischenplatte, die die Düsen trägt, gebildet. Der zweite Bereich des Reaktorbodens ist durch die Zwischenplatte und eine Bodenplatte, die die Versorgungsanschlüsse für die Filamente trägt, gebildet. In den so gebildeten ersten Bereich wird das Kühlwasser geführt, um somit den Reaktorboden zu kühlen.

Im zweiten Bereich wird das Monosilan eingespeist, damit dieses durch die Düsen in den Innenraum des Reaktors austreten kann. Die Düsen sind als zylinderförmige Verbindung zwischen der Zwischenplatte und der dem Innenraum des Reaktors zugewandten Platte ausgebildet. Aufgrund dieser Konstruktion ist sichergestellt, dass das im zweiten Bereich befindliche Monosilan sicher in den Innenraum des Reaktors gelangt ohne dabei in Kontakt mit dem Kühlwasser zu gelangen, welches sich im ersten Bereich befindet. Der Kontakt zwischen Wasser bzw. Luft und dem Prozessgas (Monosilan) muss unbedingt vermieden werden, da sonst eine erhöhte Explosionsgefahr besteht.

Die Versorgungsanschlüsse für die Filamente sind als ein Hochspannungsanschluss und als Kühlwasseranschlüsse ausgebildet.

Die Filamente selbst sitzen in einem Grafitadapter. Dieser Grafitadapter greift in einen Grafitspannring ein, der selbst über einen Quarzring mit der Platte zusammenwirkt. Die Kühlwasseranschlüsse für die Filamente können in Form von Schnellkupplungen ausgebildet sein.

Das Innenrohr sitzt in einem Topf auf der Bodenplatte. Der Topf ist dabei derart ausgebildet, dass er den ersten Bereich und den zweiten Bereich abdichtet. In dem Topf ist ferner eine Halterung für das Innenrohr geführt, wobei eine radiale Dichtung den Topf, die Halterung und den Reaktorraum gegeneinander abdichtet. Das Innenrohr selbst hat zwei separate Kühlwasserkreisläufe ausgebildet. Die Zuführung des Kühlwassers zu den einzelnen Kühlwasserkreisläufen des Innenrohrs erfolgt über getrennte Leitungen, die mit dem Innenrohr ebenfalls über Schnellkupplungen miteinander verbunden sind.

Ausgehend vom Innenrohr ist eine Abführleitung für das verbrauchte Monosilan geführt. Diese Abführleitung ist durch die Halterung und den Topf geführt, um so das verbrauchte Monosilan unterhalb des Reaktorbodens abzuführen.

Im Folgenden sollen Ausführungsbeispiele den erfindungsgemäßen Reaktor und dessen Vorteile anhand der beigefügten Figuren näher erläutern.
- Figur 1: zeigt eine Schnittansicht durch den erfindungsgemäßen Reaktor.
- Figur 2: zeigt eine perspektivische Schnittansicht durch den erfindungsgemäßen Reaktor.
- Figur 3: zeigt eine Bodenansicht des Reaktors, wobei die Versorgungsanschlüsse für die Filamente zu erkennen sind.
- Figur 4: zeigt eine vergrößerte perspektivische Darstellung des in Figur 2 mit B gekennzeichneten Bereichs des Reaktorbodens.
- Figur 5: zeigt eine Detailansicht der Anbringung des Innenrohrs am Reaktorboden.
- Figur 6: zeigt eine vergrößerte Darstellung des in Figur 5 mit F gekennzeichneten Bereichs.
- Figur 7: zeigt eine vergrößerte Darstellung des in Figur 5 mit G gekennzeichneten Bereichs.
- Figur 8: zeigt eine Schnittansicht des erfindungsgemäßen Innenrohrs.
- Figur 9: zeigt eine Seitenansicht des erfindungsgemäßen Innenrohrs.
- Figur 10: zeigt die Führung des Kühlwassers in der Doppelwandung des Innenrohrs.
- Figur 11: zeigt eine vergrößerte Darstellung des in Figur 10 mit A gekennzeichneten Bereichs.

Für gleiche oder gleich wirkende Elemente der Erfindung werden identische Bezugszeichen verwendet. Ferner werden der Übersicht halber nur Bezugszeichen in den einzelnen Figuren dargestellt, die für die Beschreibung der jeweiligen Figur erforderlich sind.

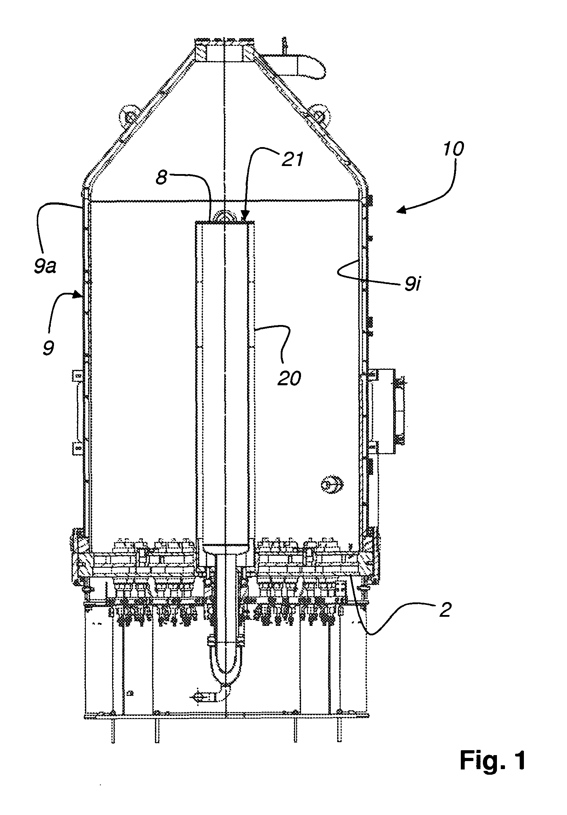

Figur 1 zeigt eine Schnittansicht des erfindungsgemäßen Reaktors 10. Dabei sind der Übersichtigkeit halber einige Teile weggelassen. Der Reaktor 10 besteht aus einer äußeren Wandung 9, die durch einen Reaktorboden 2 abgeschlossen ist. Die Wandung 9 des Reaktors 10 besteht aus einer äußeren Wand 9a und einer inneren Wand 9i. Die äußere Wand 9a und die innere Wand 9b sind voneinander beabstandet, so dass dadurch ein Zwischenraum gebildet ist. In diesem Zwischenraum wird Kühlwasser geführt, um im Innern des Reaktors 10 eine definierte Prozesstemperatur zu erhalten. Ebenso ist der Reaktorboden 2 aus mindestens einem Zwischenraum aufgebaut, in dem ebenfalls Kühlwasser geführt wird. Zentral im Innern des Reaktors 10 ist ein Innenrohr 20 angeordnet. Das Innenrohr 20 besitzt ein freies Ende, welches vom Reaktorboden 2 beabstandet ist. Dieses freie Ende 21 des Innenrohrs 20 bildet eine Gasaustrittsöffnung 8. Durch die Gasaustrittsöffnung 8 kann verbrauchtes Monosilan zu einer Anreicherung und/oder Aufbereitung geleitet werden. Die Ableitung des verbrauchten Monosilans geschieht bei dem erfindungsgemäßen Reaktor 10 durch den Reaktorboden 2.

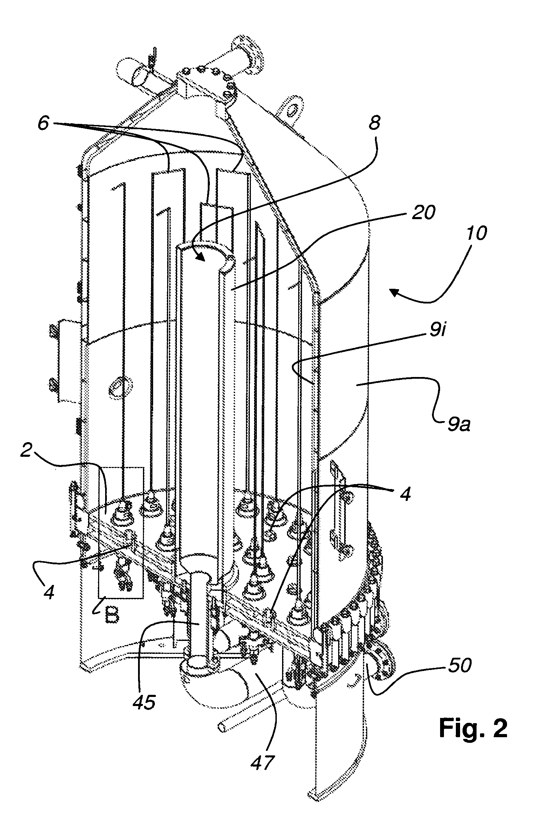

Figur 2 zeigt eine perspektivische Schnittansicht des erfindungsgemäßen Reaktors 10. Der Reaktorboden 2 hat eine Vielzahl von Düsen 4 ausgebildet, durch die Monosilan in den Innenraum des Reaktors 10 eintritt. Ebenfalls ist auf dem Reaktorboden eine Vielzahl von Filamentstäben 6 befestigt, an denen sich das polykristalline Silizium aus dem Monosilan während des Prozesses abscheidet. Wie bereits in der Beschreibung zu Figur 1 erwähnt, weist das Innenrohr 20 eine Gasaustrittsöffnung 8 auf, durch die das verbrauchte Monosilan einer Anreicherung und/oder Aufbereitung zugeführt wird. Die Gasaustrittsöffnung 8 des Innenrohrs 20 ist dabei deutlich vom Reaktorboden 2 beabstandet. Dies ist deshalb notwendig, damit sichergestellt ist, dass frisch in den Reaktor 10 eintretendes Monosilan sofort wieder durch die Gasaustrittsöffnung für verbrauchtes Monosilan austritt. Das Innenrohr 20 ist ebenfalls doppelwandig ausgebildet und kann somit mit Wasser gekühlt werden, damit an den Filamentstäben 6 immer eine konstante Prozesstemperatur vorherrscht. Das Innenrohr 20 ist durch den Reaktorboden 2 geführt. Mit einer Abführleitung 45 wird das verbrauchte Monosilan zur Anreicherung und/oder Wiederaufbereitung geführt. Ebenso ist mit dem Reaktorboden 2 eine Zuführleitung 50 für frisches Monosilan vorgesehen. Diese Zuführleitung 50 endet im mehrschichtig aufgebauten Reaktorboden 2. Von dort aus wird das Monosilan innerhalb des Reaktorbodens 2 auf die verschiedenen Düsen 4 verteilt und tritt dann in den Innenraum des Reaktors 10 ein. Die Düsen 4 und die in entsprechenden Halterungen 7 sitzenden Filamentstäbe 6 sind gleich verteilt um das Innenrohr 20 angeordnet, welches im Zentrum des Reaktorbodens 2 angeordnet ist.

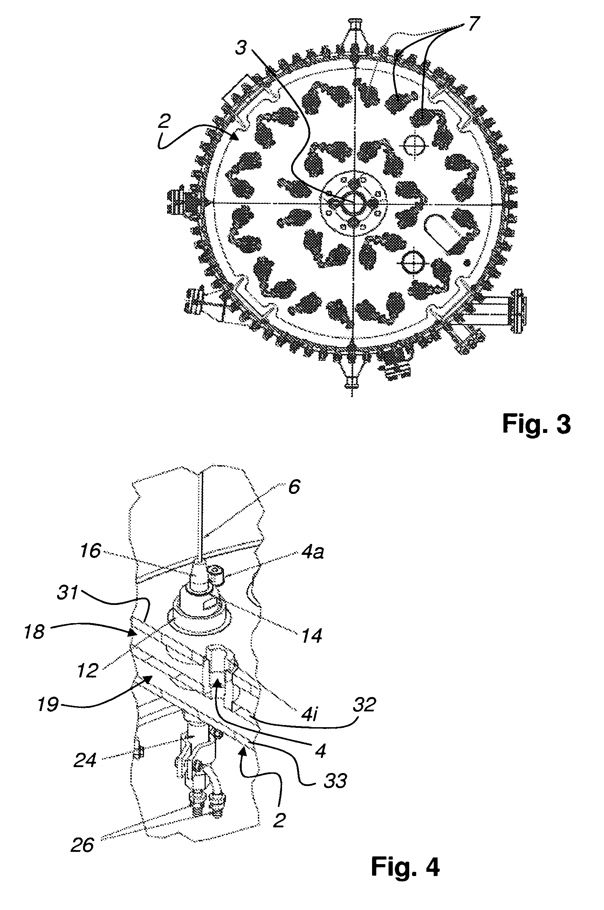

Figur 3 zeigt eine Bodenansicht des Reaktorbodens 2. Das Innenrohr ist im Zentrum 3 des Reaktorbodens 2 befestigt. Um das Zentrum 3 des Reaktorbodens herum sind die Halterungen 7 und die Versorgungsanschlüsse 24, 26 für die Filamente 6 angebracht. Die Filamentstäbe 6 bzw. deren Halterungen 7 werden von unterhalb des Reaktorbodens 2 mit Kühlwasser und einer Hochspannung versorgt.

Figur 4 zeigt eine vergrößerte perspektivische Darstellung des in Figur 2 mit B gekennzeichneten Bereichs des Reaktors 10. Wie bereits oben erwähnt, ist der Reaktorboden mehrschichtig aufgebaut. Der Reaktorboden 2 besteht aus einem ersten Bereich 18 und einem zweiten Bereich 19. Der erste Bereich 18 ist durch eine im Innenraum des Reaktors 10 zugewandte Platte 31 und einer Zwischenplatte 32 gebildet. Der zweite Bereich 19 ist durch die Zwischenplatte 32 und einer Bodenplatte 33 gebildet. In der Zwischenplatte 32 sind Öffnungen ausgebildet, die die Düsen 4 für das Monosilan tragen. Die Düsen enden in der dem Reaktorraum zugewandten Platte 31 mit einem Innenring 4i. Über den Innenring 4i ist ein entsprechender Außenring 4a gestülpt. Die Außenringe 4a sitzen auf der dem Reaktorinnenraum zugewandten Platte 31 und bilden somit die Austrittsöffnungen für das Monosilan. Folglich wird das frische siliziumhaltige Gas in den zweiten Bereich 19 geleitet und verteilt sich entsprechend in diesem zweiten Bereich 19, um durch die Düsen 4 in den Reaktor 10 einzutreten. Im ersten Bereich 18 wird Kühlwasser geführt. Die Filamente 6 sitzen in einem Grafitadapter 16. Der Grafitadapter 16 greift in einen Spannring 14 aus Grafit ein. Der Spannring 14 sitzt wiederum in einem Quarzring 12. Unterhalb der Bodenplatte ragen die Versorgungsanschlüsse 24 und 26 für die Filamentstäbe heraus. Der Versorgungsanschluss 24 dient zur Spannungsversorgung der Filamente 6. Der Versorgungsanschluss 24 ist als Hochspannungselektrode ausgeführt und versorgt die Filamente 6 mit einer Hochspannung von ca. 10.000 Volt. Die Versorgungsanschlüsse 26 sind als Kühlwasseranschlüsse ausgebildet, um die Halterungen 7 der Filamente 6 auf einer entsprechenden Prozesstemperatur zu halten. Die Filamente 6 selbst bestehen aus einem hochreinen Polysiliziumstab, der etwa einen Durchmesser von 8 mm besitzt.

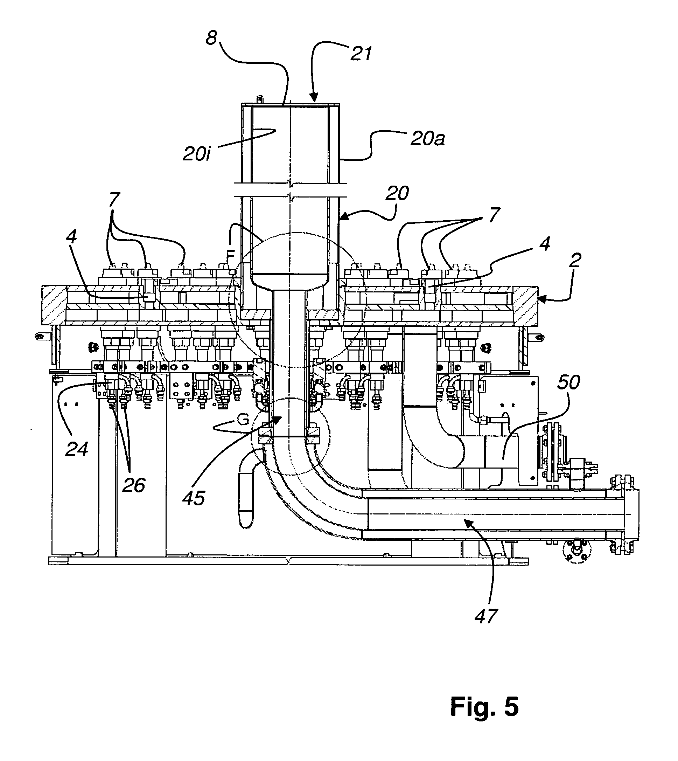

Figur 5 zeigt eine Darstellung der Montage des Innenrohrs 20 auf dem Reaktorboden 2 des Reaktors 10. Wie bereits mehrfach erwähnt, sind auf dem Reaktorboden 2 die Halterungen 7 für die Filamente 6 vorgesehen. Ebenso sind in dem Reaktorboden 2 die Düsen 4 für das Monosilan ausgebildet. Unterhalb des Reaktorbodens 2 sind die Versorgungsanschlüsse 24 und 26 für die Filamente vorgesehen. Das Innenrohr 20 besteht aus einer äußeren Wand 20a und einer inneren Wand 20i. In dem durch die äußere Wand 20a und die innere Wand 20i gebildeten Zwischenraum kann Kühlwasser geführt werden. Über der Gasaustrittsöffnung 8 des Innenrohrs 20 ist das Innenrohr verjüngt und mündet in die Abführleitung 45. Die Abführleitung 45 tritt gerade durch den Reaktorboden 2. Anschließend erfolgt eine Umlenkung, so dass eine sich an die Abführleitung 45 anschließende weitere Abführleitung 47 parallel zum Reaktorboden 2 verläuft und somit das verbrauchte Monosilan aus dem Bereich des Reaktors unterhalb des Reaktorbodens 2 herausleitet. Ebenso wird das frische Monosilan mit einer Zuführleitung 50 von unten an den Reaktorboden 2 herangeführt.

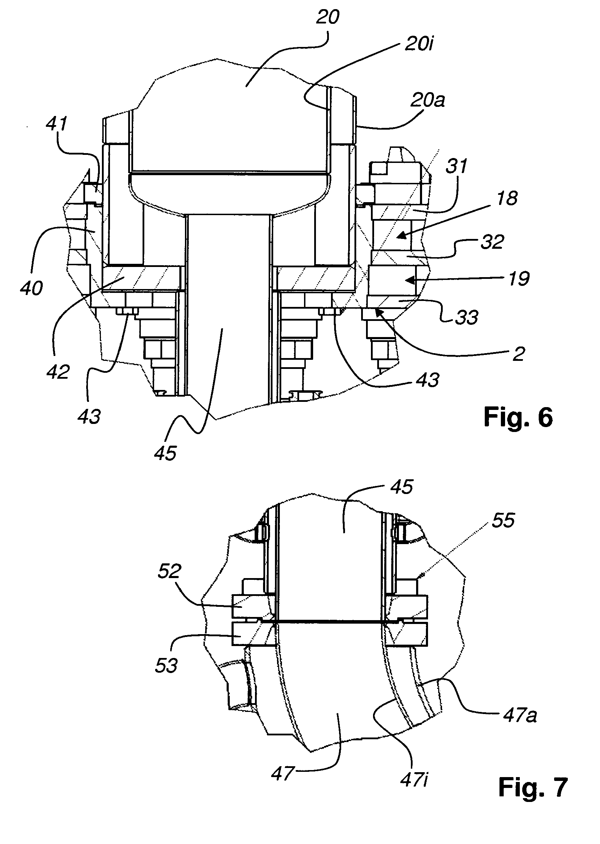

Figur 6 zeigt eine vergrößerte Darstellung des in Figur 5 mit F gekennzeichneten Bereichs, der die Befestigung bzw. Montage des Innenrohrs 20 auf dem Reaktorboden 2 verdeutlicht. Wie bereits erwähnt ist das Innenrohr 20 aus einer äußeren Wand 20a und einer inneren Wand 20i gebildet. Das Innenrohr 20 sitzt in einem Topf 40, der den ersten Bereich 18 und den zweiten Bereich 19 des Reaktorbodens 2 radial abdichtet. In den Topf 40 ist eine Halterung 42 eingepasst, in der das Innenrohr 20 sitzt. Die Halterung 42 trägt ferner eine radial umlaufende Dichtung 41, die somit den Topf 40, die Halterung 42 und den Innenraum des Reaktors 10 gegeneinander abdichtet. Im Bereich der Halterung 42 ist das Innenrohr verjüngt ausgebildet und formt dadurch eine Abführleitung 45, welche senkrecht durch den Reaktorboden 2 geführt ist. Mittels mehrerer Schrauben ist die Halterung 42 mit der Bodenplatte 33 des Reaktorbodens fest verbunden.

Figur 7 zeigt den in Figur 5 mit G gekennzeichneten Bereich. Hier ist der Übergang von der senkrechten Abführleitung 45 zu einer im Wesentlichen parallel zum Reaktorboden 2 verlaufenden Abführleitung 47 dargestellt. Die senkrechte Abführleitung 47 hat einen Flansch 52 ausgebildet, der mit einem gekrümmten Übergang der Abführleitung 47 zusammenwirkt. Der gekrümmte Übergang der Abführleitung 47 hat ebenfalls einen entsprechenden Flansch 53 ausgebildet. Mittels mehrerer Schrauben 55 werden die Flansche 52 der senkrechten Abführleitung 45 und der Flansch 53 der weiteren Abführleitung 47 miteinander verbunden. Die letztendlich im Wesentlichen parallel zum Reaktorboden 2 verlaufende Abführleitung 47 ist ebenfalls doppelwandig ausgebildet. Die Abführleitung 47 umfasst folglich eine äußere Wand 47a und eine innere Wand 47i.

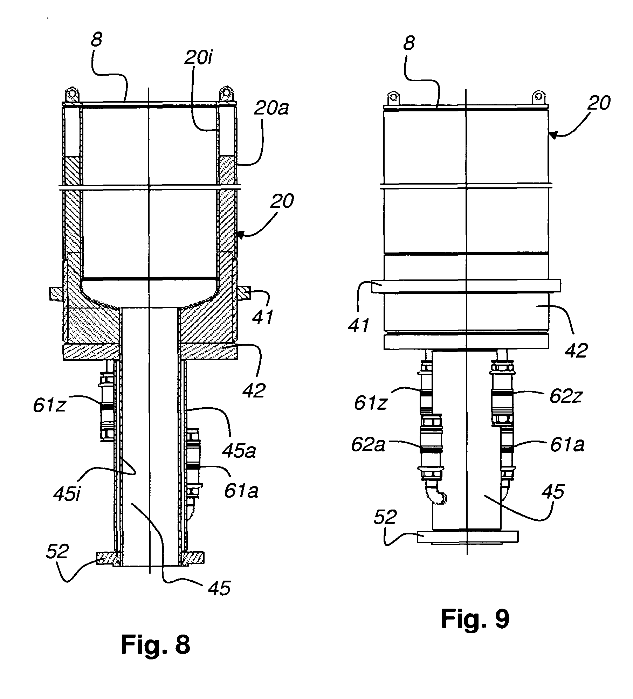

Figur 8 zeigt eine Schnittdarstellung des Innenrohrs 20, welches in den Reaktor 10 eingesetzt ist, um das verbrauchte Monosilan aus dem Reaktor abzuführen und dieses Gas einer Aufbereitung zuzuführen. Wie bereits erwähnt, ist das Innenrohr 20 doppelwandig ausgebildet und besteht aus einer äußeren Wand 20a und einer inneren Wand 20i. Die Gasaustrittsöffnung 8, durch welche das teilweise verbrauchte Monosilan in das Innenrohr 20 eintritt, ist gegenüber der Halterung 42 mit der radial umlaufenden Dichtung 41 vorgesehen. In dem Bereich der Halterung 42 mündet das Innenrohr 20 in eine sich gegenüber das Innenrohr verjüngende Abführleitung 45. Diese Abführleitung 45 ist ebenfalls doppelwandig ausgebildet und umfasst somit eine äußere Wand 45a und eine innere Wand 45i. Am freien Ende der Abführleitung 45 ist der Flansch 52 vorgesehen, über den die Abführleitung 45 an eine weitere Abführleitung 47 (siehe Figur 7) montiert werden kann. Eine erste und zweite Zuleitung 61 z und 62z sowie eine erste und zweite Ableitung 61a und 62a für das Kühlwasser sind außen an der Abführleitung 45 geführt.

Figur 9 zeigt eine Seitenansicht des Innenrohrs 20, welches in den Reaktor 10 montiert wird. Die Verjüngung vom Durchmesser des Innenrohrs 20 auf den Durchmesser der senkrechten Abführleitung 45 erfolgt im Wesentlichen im Inneren der Halterung 42, die in den Topf 40 des Reaktorbodens 2 eingesetzt wird. Somit ist die Abmessung des Innenrohrs 20 konstant und zeigt somit keine Abstufung auf, die evtl. im Bereich des Reaktorbodens dort am ersten Bereich 18 bzw. am zweiten Bereich 19 zu Dichtungsproblemen führen würde. Es ist nämlich von außerordentlicher Bedeutung bei dem Verfahren, das Kühlwasser vom Kontakt mit dem Monosilan fern zu halten. Wie aus Figur 8 und Figur 9 zu erkennen ist, ist die erste und die zweite Zuleitung 61z und 62z für das Kühlwasser des Innenrohrs 20 außen an der Abführleitung 45 geführt. Analog dazu ist die erste und zweite Ableitung 61 a und 62a des Kühlwassers aus dem Innenrohr 20 außen an der Abführleitung 45 für das Monosilan geführt. Die Verbindungen für den Durchfluss des Kühlwassers werden für die Zuleitungen 61 z und 62z und die Ableitungen 61a und 62a jeweils über eine Schnellkupplung hergestellt.

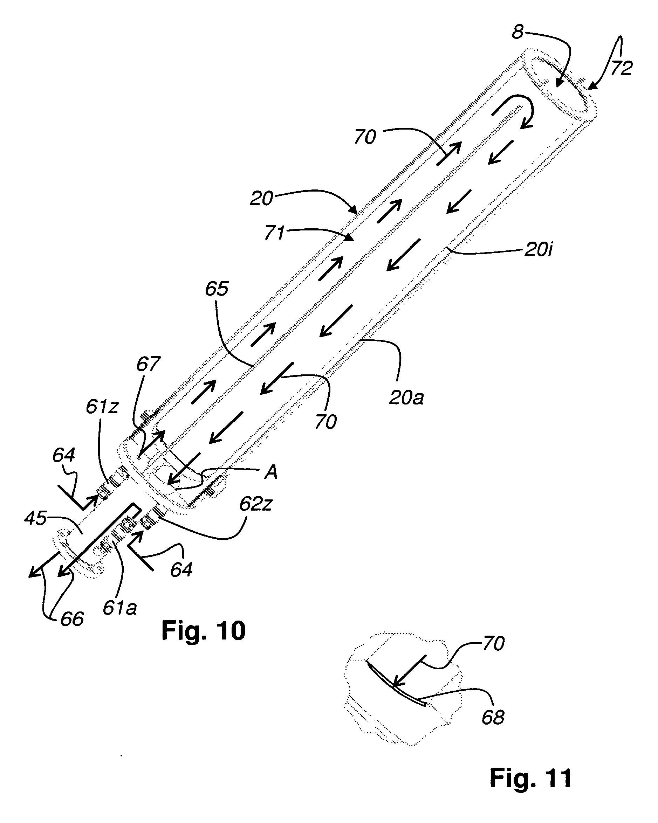

Figur 10 zeigt eine perspektivische Ansicht des Innenrohrs 20, aus der der Verlauf 70 des Kühlwassers innerhalb des durch die äußere Wand 20a und die innere Wand 20i gebildeten Zwischenraums ersichtlich ist. Eine Vielzahl von Pfeilen stellt den Verlauf 70 des Kühlwassers im Zwischenraum dar. Da eine erste Zuleitung und eine zweite Zuleitung 61 z und 62z vorgesehen sind, sind im Zwischenraum zwei Kühlwasserkreisläufe ausgebildet. Über die erste Zuleitung 61 z erfolgt der Kühlwasserzulauf 64 zum ersten Kühlwasserkreislauf 71. Über die zweite Zuleitung 62z erfolgt der Kühlwasserzulauf 64 zum zweiten Kühlwasserkreislauf (nicht dargestellt). Das Kühlwasser gelangt über eine Öffnung 67 in den Zwischenraum des Innenrohrs 20. Die Darstellung der Figur 11 zeigt den in Figur 10 mit A gekennzeichneten Bereich in der vergrößerten Darstellung. Der Verlauf 70 des Kühlwassers tritt durch eine schlitzförmige Öffnung 68 aus dem Zwischenraum aus und gelangt zu der ersten Ableitung 61 a für das Kühlwasser.

Zur Ausbildung des in Figur 10 gezeigten Verlaufs 70 des Kühlwassers ist im Zwischenraum eine Trennwand 65 vorgesehen. Durch diese Trennwand 65 ist sichergestellt, dass der erste Kühlwasserkreislauf 71 von der Öffnung 67 zu der schlitzförmigen Öffnung 68 verläuft. Von der schlitzförmigen Öffnung 68 wird das Kühlwasser einen dem ersten Kühlwasserkreislauf 71 bzw. dem zweiten Kühlwasserkreislauf zugeordneten Kühlwasserablauf 66 zugeführt.Die Erfindung wurde unter Bezugnahme auf eine bevorzugte Ausführungsform beschrieben.

## Patentansprüche

1. Reaktor (10) zur Herstellung von polykristallinem Silizium nach dem Monosilan-Prozess, mit einem Reaktorboden (2), der eine Vielzahl von Düsen (4) ausgebildet hat, durch die ein siliziumhaltiges Gas einströmt, mehreren ebenfalls am Reaktorboden (2) montierten Filamentstäben (6) und einer von den Düsen (4) beabstandeten Gasaustrittöffnung (8) zum Zuführen von verbrauchtem Monosilan zu einer Anreicherung und/oder Aufbereitung, **dadurch gekennzeichnet, dass** die Gasaustrittöffnung (8) an einem freien Ende (21) eines Innenrohrs (20) ausgebildet ist und dass das Innenrohr (20) durch den Reaktorboden (2) geführt ist und dass das Innenrohr (20) eine äußere Wand (20a) und eine innere Wand (20i) besitzt und somit einen Zwischenraum ausbildet, in dem mindestens ein Kühlwasserkreislauf (71) geführt ist.

2. Reaktor (10) nach Anspruch 1, **dadurch gekennzeichnet, dass** das Innenrohr (20) im Zentrum des (3) Reaktorbodens (2) sitzt und dass im Reaktorboden (2) eine Vielzahl von Gasaustrittsöffnungen (4) und Halterungen für die Filamentstäbe (6) das Innenrohr (20) umgeben.

3. Reaktor nach Anspruch 1, **dadurch gekennzeichnet, dass** der im Zwischenraum des Innenrohrs (20) ausgebildete mindestens eine Kühlwasserkreislauf (71) eine annähernd gleiche Prozesstemperatur an den Filamentstäben (6) gewährleistet.

4. Reaktor nach Anspruch 3, **dadurch gekennzeichnet, dass** das Innenrohr (20) doppelwandig ausgebildet ist.

5. Reaktor nach einem der Ansprüche 1 und 4, **dadurch gekennzeichnet, dass** der Reaktor (10) und der Reaktorboden (2) als Doppelmantel aus einer inneren Wand (9i) und einer äußeren Wand (9a)ausgebildet ist und dass sich Wasser zur Kühlung im Doppelmantel befindet.

6. Reaktor nach Anspruch 5, **dadurch gekennzeichnet, dass** der Reaktorboden (2) einen ersten Bereich (18) und einen zweiten Bereich (19) umfasst, wobei der erste Bereich (18) durch eine dem Innenraum des Reaktors (10) zugewandten Platte (31) einer Zwischenplatte (32), die die Düsen (4) trägt, gebildet ist und wobei der zweite Bereich (19) durch die Zwischenplatte (32) und einer Bodenplatte (33), die Versorgungsanschlüsse (24, 26) für die Filamente (6) trägt, gebildet ist.

7. Reaktor nach Anspruch 6, **dadurch gekennzeichnet, dass** im ersten Bereich (18) Kühlwasser geführt ist.

8. Reaktor nach Anspruch 6, **dadurch gekennzeichnet, dass** im zweiten Bereich (19) unverbrauchtes Monosilan geführt ist, das durch die Vielzahl von Düsen (4) im Reaktorboden (2) in den Reaktor (10) eintritt.

9. Reaktor nach Anspruch 6, **dadurch gekennzeichnet, dass** die Versorgungsanschlüsse (24, 26) für die Filamente (6) ein Hochspannungsanschluss und Kühlwasseranschlüsse sind.

10. Reaktor nach einem der Ansprüche 6 bis 9, **dadurch gekennzeichnet, dass** die Filamente (6) in einem Grafitadapter (16) sitzen, der in einen Grafitspannring (14) eingreift, der selbst über einen Quarzring (12) mit der Platte (31) zusammenwirkt.

11. Reaktor nach einem der Ansprüche 1 bis 10, **dadurch gekennzeichnet, dass** das Innenrohr (20) in einem Topf (40) auf der Bodenplatte (33) sitzt, der den ersten Bereich (18) und den zweiten Bereich (19) abdichtet, dass im Topf (40) eine Halterung (42) für das Innenrohr (20) geführt ist, wobei eine radiale Dichtung (41) den Topf (40), die Halterung (42) und den Reaktorraum gegeneinander dichtet.

12. Reaktor nach Anspruch 11, **dadurch gekennzeichnet, dass** vom Innenrohr (20) eine Abführleitung (45) für das verbrauchte Monosilan durch die Halterung (42) und den Topf (40) geführt ist, die das verbrauchte Monosilan unter dem Reaktorboden (2) abführt.

13. Reaktor nach einem der Ansprüche 1 bis 12, **dadurch gekennzeichnet, dass** im Zwischenraum ein erster Kühlwasserkreislauf (71) und ein zweiter Kühlwasserkreislauf (72) ausgebildet sind und dass jeder Kühlwasserkreislauf (71, 72) durch eine Trennwand 65 derart unterteilt ist, dass im Zwischenraum ein Verlauf (70) des Kühlwassers von einer Öffnung (67) zu einer schlitzförmigen Öffnung (68) ausgebildet ist.

## Claims

1. A reactor (10) for producing polycrystalline silicon using the monosilane process, having a reactor base plate (2) which has a multiplicity of nozzles (4) formed therein through which a silicon-containing gas flows, a plurality of filament rods (6) likewise mounted on the reactor base plate (2), and a gas outlet opening (8) at a distance from the nozzles (4) for feeding used monosilane to an enrichment and/or treatment stage, **characterized in that** the gas outlet opening (8) is formed at a free end (21) of an inner tube (20), and **in that** the inner tube (20) is conducted through the reactor base plate (2), and **in that** the inner tube (20) has an outer wall (20a) and an inner wall (20i) and thus forms an intermediate space in which at least one cooling water circuit (71) is conducted.

2. The reactor (10) as claimed in claim 1, **characterized in that** the inner tube (20) is located in the center (3) of the reactor base plate (2), and **in that** a multiplicity of gas outlet openings (4) and holders for the filament rods (6) surround the inner tube (20) in the reactor base plate (2).

3. The reactor as claimed in claim 1, **characterized in that** the at least one cooling water circuit (71) formed in the intermediate space of the inner tube (20) ensures an approximately equal process temperature at the filament rods (6).

4. The reactor as claimed in claim 3, **characterized in that** the inner tube (20) is constructed so as to be double-walled.

5. The reactor as claimed in any one of claims 1 and 4, **characterized in that** the reactor (10) and the reactor base plate (2) are constructed as a double-walled jacket of an inner wall (9i) and an outer wall (9a), and **in that** water for cooling is situated in the double-walled jacket.

6. The reactor as claimed in claim 5, **characterized in that** the reactor base plate (2) comprises a first region (18) and a second region (19), wherein the first region (18) is formed by a plate (31) facing the interior of the reactor (10) and an intermediate plate (32) which carries the nozzles (4), and wherein the second region (19) is formed by the intermediate plate (32) and a bottom plate (33) which carries the supply connections (24, 26) for the filaments (6).

7. The reactor as claimed in claim 6, **characterized in that** cooling water is conducted in the first region (18).

8. The reactor as claimed in claim 6, **characterized in that** unused monosilane is conducted in the second region (19), which unused monosilane enters into the reactor (10) through the multiplicity of nozzles (4) in the reactor base plate (2).

9. The reactor as claimed in claim 6, **characterized in that** the supply connections (24, 26) for the filaments (6) are a high-voltage connection and cooling water connections.

10. The reactor as claimed in any one of claims 6 to 9, **characterized in that** the filaments (6) are located in a graphite adaptor (16) which engages into a graphite clamping ring (14) which itself interacts with the plate (31) via a quartz ring (12).

11. The reactor as claimed in any one of claims 1 to 10, **characterized in that** the inner tube (20) is located in a pot (40) on the bottom plate (33) which seals the first region (18) and the second region (19), **in that** a holder (42) for the inner tube (20) is conducted in the pot (40), wherein a radial seal (41) seals the pot (40), the holder (42) and the reactor space from one another.

12. The reactor as claimed in claim 11, **characterized in that** a discharge line (45) for the used monosilane is conducted from the inner tube (20) through the holder (42) and the pot (40), which discharge line discharges the used monosilane below the reactor base plate (2).

13. The reactor as claimed in any one of claims 1 to 12, **characterized in that**, in the intermediate space, a first cooling water circuit (71) and a second cooling water circuit (72) are formed, and **in that** each cooling water circuit (71, 72) is subdivided by a partition (65) in such a manner that in the intermediate space a course (70) of the cooling water is formed from an opening (67) to a slot-shaped opening (68).

## Revendications

1. Réacteur (10) pour la production de silicium polycristallin selon le procédé Monosilane, avec un fond de réacteur (2), qui comporte une pluralité de buses (4) par lesquelles pénètre un gaz contenant du silicium, avec plusieurs barres de filaments (6) également montées sur le fond de réacteur (2) et avec une ouverture de sortie de gaz (8) espacée des buses (4) pour envoyer du monosilane usé à un enrichissement et/ou à une préparation, **caractérisé en ce que** l'ouverture de sortie de gaz (8) est formée à une extrémité libre (21) d'un tube intérieur (20) et **en ce que** le tube intérieur (20) est conduit à travers le fond de réacteur (2) et **en ce que** le tube intérieur (20) possède une paroi extérieure (20a) et une paroi intérieure (20i) et forme ainsi une chambre intermédiaire, dans laquelle au moins un circuit d'eau de refroidissement (71) est conduit.

2. Réacteur (10) selon la revendication 1, **caractérisé en ce que** le tube intérieur (20) est placé au centre (3) du fond de réacteur (2) et **en ce qu'**une pluralité d'ouvertures de sortie de gaz (4) et de supports pour les barres de filaments (6) entourent le tube intérieur (20) dans le fond de réacteur (2).

3. Réacteur selon la revendication 1, **caractérisé en ce que** ledit au moins un circuit d'eau de refroidissement (71) formé dans la chambre intermédiaire du tube intérieur (20) garantit une température de traitement pratiquement égale sur les barres de filaments (6).

4. Réacteur selon la revendication 3, **caractérisé en ce que** le tube intérieur (20) est réalisé à double paroi.

5. Réacteur selon l'une quelconque des revendications 1 et 4, **caractérisé en ce que** le réacteur (10) et le fond de réacteur (2) sont réalisés sous la forme d'une enveloppe double composée d'une paroi intérieure (9i) et d'une paroi extérieure (9a), et **en ce qu'**il se trouve de l'eau dans l'enveloppe double pour le refroidissement.

6. Réacteur selon la revendication 5, **caractérisé en ce que** le fond de réacteur (2) comprend une première région (18) et une deuxième région (19), dans lequel la première région (18) est formée par une plaque (31) tournée vers l'espace intérieur du réacteur (10) et une plaque intermédiaire (32) qui porte les buses (4), et dans lequel la deuxième région (19) est formée par la plaque intermédiaire (32) et une plaque de fond (33), qui porte des raccords d'alimentation (24, 26) pour les filaments (6).

7. Réacteur selon la revendication 6, **caractérisé en ce que** de l'eau de refroidissement est conduite dans la première région (18).

8. Réacteur selon la revendication 6, **caractérisé en ce que** du monosilane non usé est conduit dans la deuxième région (19), et pénètre dans le réacteur (10) par la pluralité de buses (4) dans le fond de réacteur (2).

9. Réacteur selon la revendication 6, **caractérisé en ce que** les raccords d'alimentation (24, 26) pour les filaments (6) sont un raccord de haute tension et des raccords d'eau de refroidissement.

10. Réacteur selon l'une quelconque des revendications 6 à 9, **caractérisé en ce que** les filaments (6) sont placés dans un adaptateur en graphite (16), qui s'engage dans une bague de serrage en graphite (14), qui coopère elle-même avec la plaque (31) par l'intermédiaire d'une bague en quartz (12).

11. Réacteur selon l'une quelconque des revendications 1 à 10, **caractérisé en ce que** le tube intérieur (20) est placé dans un godet (40) sur la plaque de fond (33), lequel réalise l'étanchéité de la première région (18) et de la deuxième région (19), **en ce qu'**un support (42) pour le tube intérieur (20) est conduit dans le godet (40), dans lequel un joint d'étanchéité radial (41) assure l'étanchéité mutuelle entre le godet (40), le support (42) et la chambre du réacteur.

12. Réacteur selon la revendication 11, **caractérisé en ce qu'**une conduite d'évacuation (45) pour le monosilane usé est conduite à partir du tube intérieur (20) à travers le support (42) et le godet (40), laquelle évacue le monosilane usé sous le fond de réacteur (2).

13. Réacteur selon l'une quelconque des revendications 1 à 12, **caractérisé en ce qu'**un premier circuit d'eau de refroidissement (71) et un deuxième circuit d'eau de refroidissement (72) sont formés dans la chambre intermédiaire, et **en ce que** chaque circuit d'eau de refroidissement (71, 72) est divisé par une paroi de séparation (65), de telle manière qu'un parcours (70) de l'eau de refroidissement depuis une ouverture (67) jusqu'à une ouverture en forme de fente (68) soit formé dans la chambre intermédiaire.
